# EUROPEAN PATENT APPLICATION

(11) **EP 3 270 671 A1**
(43) Date of publication of application: **17.01.2018**
(21) Application number: 17180445.3
(22) Date of filing: 10.07.2017
(51) Int. Cl.: H05K 7/14

(54) **ZERO INSERTION FORCE CARD GUIDE**

(30) Priority: 11.07.2016 US 201615206650
(71) Applicant: Hamilton Sundstrand Corporation, Charlotte, NC 28217-4578 (US)
(72) Inventor: COONEY, Robert C., Janesville, WI Wisconsin 53546 (US)
(74) Representative: Hughes, Andrea Michelle

(57) **Abstract**

A housing for use with line replaceable modules includes a housing body (102), an access cover (104) associated with the housing body, a guide body (111) disposed within the housing body, a guide cam (114) disposed within the guide body, wherein the guide cam includes at least one guide feature (115), a clamping cam (112) in sliding contact with the guide cam, wherein the clamping cam includes at least one follower (113) to interface with the at least one guide feature, and an actuating lever (120) associated with the clamping cam to interface with the access cover, wherein the actuating lever translates the clamping cam relative to the guide cam.

## Description

### BACKGROUND

The subject matter disclosed herein relates to card guides, and more particularly, to zero insertion force card guides for aircraft.

Line replaceable modules can be utilized within an aircraft to allow for easily replaceable components for maintenance and upgrades. Card guides may utilize frictional forces or wedge-locks to retain line replaceable modules. Often, high friction forces or the use of tools to actuate the card guide mechanisms may lead to difficult installation procedures.

### BRIEF SUMMARY

According to an embodiment, a card guide to be used in a housing with an access cover includes a guide body, a guide cam disposed within the guide body, wherein the guide cam includes at least one guide feature, a clamping cam in sliding contact with the guide cam, wherein the clamping cam includes at least one follower to interface with the at least one guide feature, and an actuating lever associated with the clamping cam to interface with the access cover, wherein the actuating lever translates the clamping cam relative to the guide cam.

According to an embodiment, a housing for use with line replaceable modules includes a housing body, an access cover associated with the housing body, a guide body disposed within the housing body, a guide cam disposed within the guide body, wherein the guide cam includes at least one guide feature, a clamping cam in sliding contact with the guide cam, wherein the clamping cam includes at least one follower to interface with the at least one guide feature, and an actuating lever associated with the clamping cam to interface with the access cover, wherein the actuating lever translates the clamping cam relative to the guide cam.

According to an embodiment, a method for engaging a line replaceable module includes disposing the line replaceable module in a guide body of a card guide within a housing, translating an actuating lever of the card guide with an access cover of the housing, translating a clamping cam relative to a guide cam in response to translation of the actuating lever, and engaging a clamping guide coupled to the clamping cam to the line replaceable module in response to translation of the clamping cam.

Technical function of the embodiments described above includes an actuating lever associated with the clamping cam to interface with the access cover, wherein the actuating lever translates the clamping cam relative to the guide cam.

Other aspects, features, and techniques of the embodiments will become more apparent from the following description taken in conjunction with the drawings.

### BRIEF DESCRIPTION OF THE DRAWINGS

The subject matter is particularly pointed out and distinctly claimed in the claims at the conclusion of the specification. The foregoing and other features, and advantages of the embodiments are apparent from the following detailed description taken in conjunction with the accompanying drawings in which like elements are numbered alike in the FIGURES:
FIG. 1 is a schematic view of one embodiment of a housing for use with line replaceable modules;
FIG. 2 is a schematic view of another embodiment of a housing for use with line replaceable modules; and
FIG. 3 is a schematic view of another embodiment of a housing for use with line replaceable modules.

### DETAILED DESCRIPTION

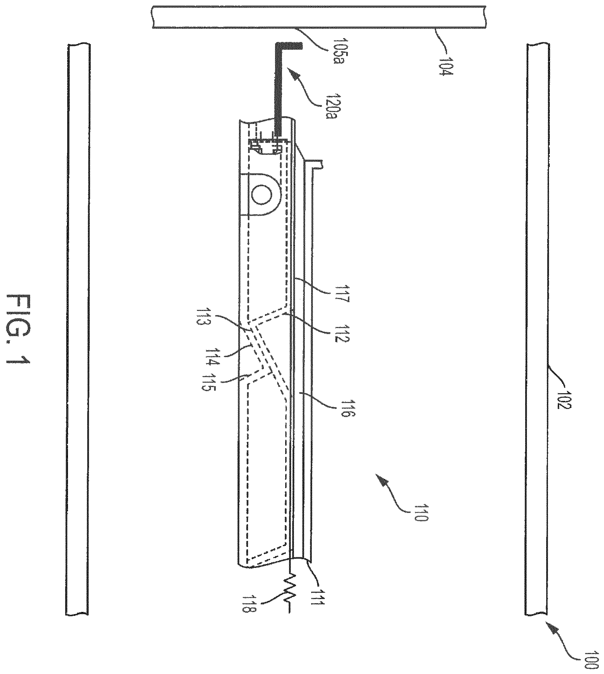

Referring to the drawings, FIG. 1 shows a housing 100. In the illustrated embodiment, the housing 100 includes a housing body 102, an access cover 104, and a card guide 110. In the illustrated embodiment, the housing body 102 and the card guide 110 can receive and retain line replaceable modules within an aircraft for maintenance and upgrades. In certain embodiments, the housing 100 can be utilized with power distribution panels for an aircraft, while in other embodiments, the housing 100 can be utilized for any suitable purpose. In the illustrated embodiment, the housing body 102 and the card guide 110 can allow for zero insertion force replacement of line replaceable modules, while further allowing for tool free installation of the line replaceable modules. Advantageously, the card guide 110 prevents damage to the line replaceable modules as well as prevents technician injury/discomfort.

In the illustrated embodiment, the housing body 102 contains the card guide 110. The housing body 102 can be formed from any suitable material. In certain embodiments, the housing body 102 is affixed to the aircraft. In the illustrated embodiment, the interior volume of the housing body 102 can be accessed through the access cover 104. The access cover 104 can be any suitable material. In the illustrated embodiment, the access cover 104 can be attached to the housing body 102 with a hinge to allow access cover 104 to be pivoted open.

In the illustrated embodiment, the access cover 104 includes a contact region 105a. The contact region 105a can interface or otherwise contact the card guide 110 when the access cover 104 is closed or closing to actuate a clamping mechanism within the card guide 110.

In the illustrated embodiment, the card guide 110 can receive and retain line replaceable modules. In the illustrated embodiment, the card guide 110 includes a body 111, a clamping cam 112, a guide cam 114, a card interface 116, and an actuating lever 120. The card guide 110 can be affixed or otherwise associated with the housing body 102. In the illustrated embodiment, the card guide 110 allows for line replaceable modules to be inserted into the card interface 116 with zero insertion force, and allows for the line replaceable modules to be engaged and retained without the use of any tools by utilizing the actuating lever 120 to engage the contact region 105a of the access cover 104.

In the illustrated embodiment, the body 111 can be formed of any suitable material. The body 111 can accommodate multiple line replaceable modules as required by the desired application.

In the illustrated embodiment, a guide cam 114 is disposed within the body 111. In the illustrated embodiment, the guide cam 114 is a stationary cam that is affixed to the body 111. The guide cam 114 includes at least one guide feature 115 that allows the clamping cam 112 to be translated in a desired direction. In the illustrated embodiment, the guide feature 115 allows for the clamping cam 112 to be translated upwardly as the clamping cam 112 is urged laterally.

In the illustrated embodiment, a clamping cam 112 translates with respect to the guide cam 114. In the illustrated embodiment, the clamping cam 112 includes at least one follower 113 to follow the guide feature 115 of the guide cam 114. The movement of the clamping cam 112 laterally allows the follower 113 to ride the guide feature 115.

In the illustrated embodiment, the clamping cam 112 is coupled to a clamping guide 117 within the card interface 116. When the clamping cam 112 is disengaged, the clamping cam 112 is translated laterally towards the access cover 104. As the clamping cam 112 is disengaged the clamping guide 117 provides no clamping force within the card interface 116. Accordingly, when the clamping cam 112 is disengaged, the card guide 110 provides zero insertion force to insert line replaceable modules within the card interface 116. In certain embodiments, the clamping cam 112 can be spring loaded to be biased to a disengaged position when no other forces are provided. In certain embodiments, the clamping cam 112 can be biased to the disengaged position by a biasing spring 118.

Line replaceable modules can be inserted or replaced within the card interface 116. The card interface 116 can include retaining features, such as slots or notches to retain the line replacement module to prevent accidental removal of the line replaceable module before the clamping cam 112 is engaged.

After line replaceable modules are inserted or replaced, the clamping cam 112 can be translated away from the access cover 104 to force the clamping cam 112 to translate the followers 113 along the guide feature 115 of the guide cam 114. As the clamping cam 112 is engaged, the clamping guide 117 provides a clamping force to retain the line replaceable module within the card interface 116.

In the illustrated embodiment, the clamping cam 112 is connected and actuated by the actuating lever 120a. In the illustrated embodiment, the actuating lever 120a is translated by contact with the contact region 105a of the access cover 104. The actuating lever 120a is attached to the clamping cam 112 to translate the clamping cam 112 in response to translation of the actuating lever 120a.

In the illustrated embodiment, when the access cover 104 is open, or not installed, the contact region 105a does not contact the actuating lever 120a or otherwise provide any force to the actuating lever 120. Therefore, the clamping cam 112 is disengaged, causing the clamping guide 117 to provide no clamping force within the card interface 116. Therefore, when the access cover 104 is open, the card guide 110 provides a zero insertion force installation of line replaceable modules.

In the illustrated embodiment, when the access cover 104 is closing, the contact region 105a contacts the actuating lever 120a to provide force to the actuating lever 120a. The translation of the actuating lever 120 translates the clamping cam 112 to an engaged position, causing the clamping guide 117 to provide a clamping force within the card interface 116. Therefore, when the access cover 104 is closed, the card guide 110 provides a clamping force to retain the line replaceable modules. Advantageously, the card guide 110 can provide a suitable clamping force without the use of tools. Further, by utilizing the actuating lever 120a, the clamping guide 116 is engaged when the access cover 104 is closed, preventing installation errors.

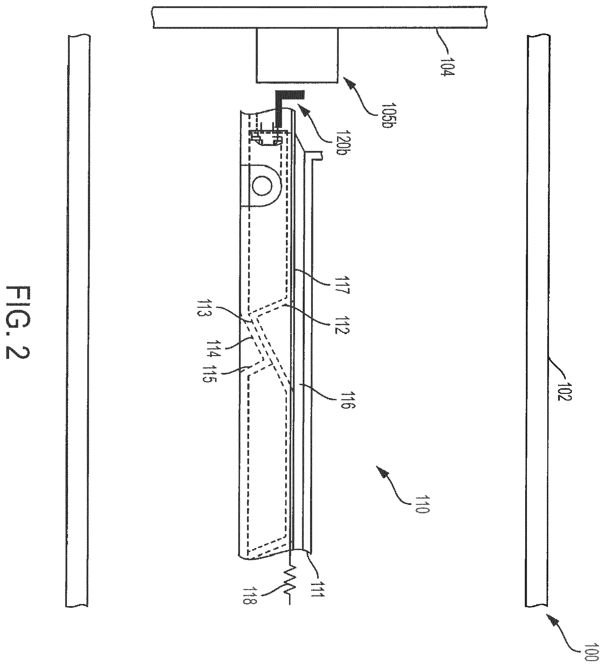

Referring to FIG. 2, another embodiment of the housing 100 is shown. In the illustrated embodiment, the access cover 104 includes a raised contact region 105b. The raised contact region 105b is of any suitable geometry that protrudes beyond the access cover 104 and provides contact with the actuating lever 120b. In the illustrated embodiment, the actuating lever 120b is shortened to allow greater technician access, prevent damage to the actuating lever 120b, and to prevent inadvertent engagement of the clamping cam 112.

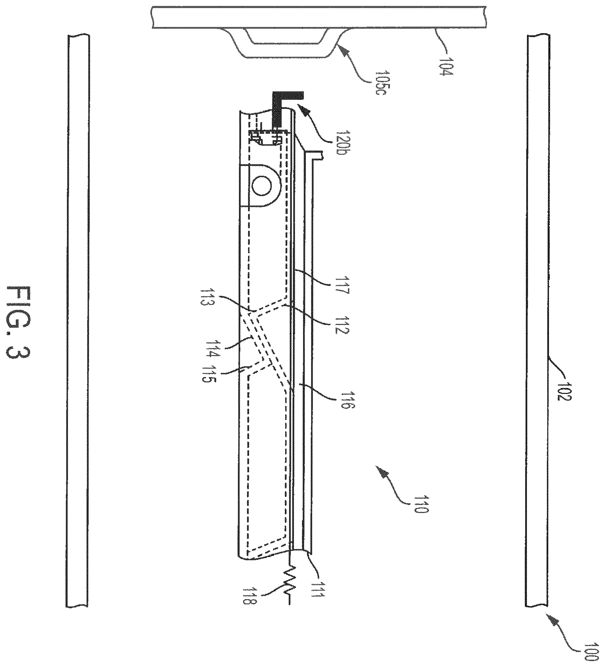

Referring to FIG. 3, another embodiment of the housing 100 is shown. In the illustrated embodiment, the access cover 104 includes a contoured raised contact region 105c. In the illustrated embodiment, the contoured raised contact region 105c can prevent installation errors as well as provide a stiffer contact area. In certain embodiments, the contoured raised contact region 105c can include dimples or other stiffening features.

The terminology used herein is for the purpose of describing particular embodiments only and is not intended to be limiting of the embodiments. While the description of the present embodiments has been presented for purposes of illustration and description, it is not intended to be exhaustive or limited to the embodiments in the form disclosed. Many modifications, variations, alterations, substitutions or equivalent arrangement not hereto described will be apparent to those of ordinary skill in the art without departing from the scope of the invention defined by the claims. Additionally, while various embodiments have been described, it is to be understood that aspects may include only some of the described embodiments. Accordingly, the embodiments are not to be seen as limited by the foregoing description, but are only limited by the scope of the appended claims.

## Claims

1. A card guide (110) to be used in a housing (100) with an access cover (104), the card guide comprising:
a guide body (111);
a guide cam (114) disposed within the guide body, wherein the guide cam includes at least one guide feature (115);
a clamping cam (112) in sliding contact with the guide cam, wherein the clamping cam includes at least one follower (113) to interface with the at least one guide feature; and
an actuating lever (120) associated with the clamping cam to interface with the access cover, wherein the actuating lever translates the clamping cam relative to the guide cam.

2. The card guide of claim 1, further comprising a clamping guide (117) coupled to the clamping cam.

3. The card guide of claim 2, wherein the clamping guide engages a line replaceable module.

4. The card guide of claim 2 or 3, wherein the clamping guide includes a retaining feature.

5. The card guide of any preceding claim, wherein the guide body receives a line replicable module.

6. The card guide of any preceding claim, wherein the clamping cam is spring loaded.

7. A housing for use with line replaceable modules, the housing comprising:
a housing body (102);
an access cover (104) associated with the housing body;
a guide body (111) disposed within the housing body;
a guide cam (114) disposed within the guide body, wherein the guide cam includes at least one guide feature (115);
a clamping cam (112) in sliding contact with the guide cam, wherein the clamping cam includes at least one follower (113) to interface with the at least one guide feature; and
an actuating lever (120) associated with the clamping cam to interface with the access cover, wherein the actuating lever translates the clamping cam relative to the guide cam.

8. The housing of claim 7, wherein the access cover is hinged to the housing body.

9. The housing of claim 7 or 8, wherein the access cover includes a contact region (105a) to contact the actuating lever.

10. The housing of claim 7, 8 or 9, further comprising a clamping guide coupled to the clamping cam.

11. The housing of claim 10, wherein the clamping guide engages the line replaceable module.

12. The housing of claim 10, wherein the clamping guide includes a retaining feature.

13. The housing of any of claims 7 to 12, wherein the guide body receives the line replicable module.

14. The housing of any of claims 7 to 13, wherein the clamping cam is spring loaded.
